# EUROPEAN PATENT APPLICATION

(11) **EP 1 122 793 A2**
(43) Date of publication of application: **08.08.2001**
(21) Application number: 01102278.7
(22) Date of filing: 31.01.2001
(51) Int. Cl.: H01L 27/15, H01L 51/40

(54) **Production of organic luminescence device**

(30) Priority: 01.02.2000 JP 2000023518
(71) Applicant: CANON KABUSHIKI KAISHA, Tokyo (JP)
(72) Inventor: Ishikawa, Nobuyuki, c/o Canon Kabushiki Kaisha, Tokyo (JP); Senoo, Akihiro, c/o Canon Kabushiki Kaisha, Tokyo (JP); Ueno, Kazunori, c/o Canon Kabushiki Kaisha, Tokyo (JP)
(74) Representative: Leson, Thomas Johannes Alois, Dipl.-Ing.

(57) **Abstract**

An organic luminescence device is formed from a pair of electrodes, and a layer of organic material disposed between the electrodes so as to cause luminescence in response to a voltage applied between the electrodes. The type of organic luminescence-device may be provided with improved luminescence performance if it is produced through a process including a wet-patterning step using an ink of the organic material within a hydrophobic organic solvent having a dissolving power of at most 5 wt. % of water at room temperature for producing the organic material layer.

## Description

### FIELD OF THE INVENTION AND RELATED ART

The present invention relates to a process for producing an organic (electro-)luminescence device using a wet patterning technique, and an organic luminescence device produced by the process.

An organic luminescence device (organic EL device) has a structure including a film comprising a fluorescent organic compound, and a cathode and an anode sandwiching the film. In the device, electrons and holes are injected into the film to be recombined to form excitons, and the excitons are then deactivated to cause luminescence as emission of light (fluorescence and phosphorescence) from the device.

Such an organic EL device is characterized by a capability of a high-luminance planar luminescence on the order of 100 - 100,000 cd/m² at a low voltage of 10 volts or below and capability of luminescence of various colors ranging from blue to red by selection of fluorescent materials.

An organic EL device has called an attention for realizing an inexpensive large-area full-color display device (Japan Electronic Data Communication Society Technical Report, vol. 89, No. 106, page 49 (1989)). According to the report, bright luminescences of blue, green and red could be obtained by using organic colorants emitting strong fluorescences in luminescence layers. The realization of a high-luminance full-color display may be attributable to the provision of an organic colorant in the form of a film capable of emitting strong fluorescence and accompanied with few pinhole defects.

Japanese Laid-Open Patent Application (JP-A) 5-78655 has proposed to form a film of organic luminescence layer comprising a mixture of an organic charge material and an organic luminescence material so as to increase the latitude of selection of luminescence material while preventing density extinction, thereby providing a high-luminance full-color device.

Regarding a structure and a process for production of full-color display panels using polymeric organic EL materials, JP-A 3-269995 has disclosed a printing process for the production while details thereof have not been disclosed, and JP-A 10-12377 has disclosed a production process using an ink jetting technique.

On the other hand, regarding the production processes for full-color display panels using low-molecular weight (monomeric) organic EL materials, it has been a general practice to rely on vacuum deposition technique using a shadow mask for the patterning as disclosed in U.S. Patent No. 5,294,869, JP-A 5-258859, JP-A 5-258860 and JP-A 5-275172. According to this technique, certain restrictions are present regarding mask positioning accuracy and aperture width, etc., so that it has been difficult to produce a high-definition full-color display panel.

As a process for alleviating the above-mentioned difficulties, JP-A 9-167684 has proposed a patterning method using a donor sheet. Even the process requires vacuum deposition for forming a luminescence layer and becomes a very complicated production process.

It is possible to obtain blue, green and red luminescences from the above-mentioned organic film EL devices using monomeric organic colorants. As is well known, however, it is necessary to dispose organic luminescence layers emitting three primary colors of luminescences at respective pixels in order to realize a full-color display medium.

Hitherto, it has been considered very difficult to form an organic luminescence layer in a pattern. This is firstly attributable to a surface instability of a reflection electrode metal, so that it is difficult to form a vacuum deposition film in an accurate pattern. Secondly, the polymer or precursor constituting the hole injection layer and organic luminescence layer are less durable against a patterning step as by photolithography. Thirdly, an organic luminescence layer formed heretofore by patterning according to printing or ink jetting has been conventionally formed after dissolution or dilution within hydrophobic solvent, and the material deterioration is liable to be caused due to water contained in the solvent, thus resulting in a lower luminescence luminance and a lower luminescence life.

### SUMMARY OF THE INVENTION

In view of the above-mentioned problems of the prior art, an object of the present invention is to provide an inexpensive process for producing an organic luminescence device exhibiting high performances, inclusive of high luminance and long life.

Another object of the present invention is to provide a process for producing an organic luminescence layer capable of full-color display by effecting high-definition and uniform patterning for respective colorants.

According to the present invention, there is provided a process for producing an organic luminescence device of the type comprising: a pair of electrodes, and a layer of organic material disposed between the electrodes so as to cause luminescence in response to a voltage applied between the electrodes; wherein
said process comprises a wet-patterning step using an ink of the organic material within a hydrophobic organic solvent having a dissolving power of at most 5 wt. % of water at room temperature for producing the organic material layer. In the wet-patterning step, a low-molecular weight (or monomeric) organic material constituting the organic material layer may be dissolved within the hydrophobic organic solvent.

In the production process adopting the wet-patterning step, a patterned organic material layer can be formed with a good pattern reproduction accuracy while retaining a uniform film thickness. As a result, a plurality of organic luminescence devices (or pixels) capable of causing luminescences of, e.g., red, green and blue, can be easily formed stably and at good accuracy on a substrate, thereby allowing inexpensive production of an organic luminescence panel capable of full-color display.

These and other objects, features and advantages of the present invention will become more apparent upon a consideration of the following description of the preferred embodiments of the present invention taken in conjunction with the accompanying drawings.

### BRIEF DESCRIPTION OF THE DRAWINGS

Figures 1, 2, 7 and 8 are schematic sectional views of active matrix-type organic EL display panels according to Examples 1, 2, 3 and 4, respectively.

Figure 3 is a schematic plan view illustrating patterns of luminescence layers formed on a thin-film semiconductor structure in a translucent manner.

Figures 4A and 4B are schematic sectional views for illustrating offset printing steps adopted in the process of the invention.

Figures 5 and 9 are schematic sectional view of passive matrix-type organic EL display panels according to Example 5 (Figure 5) and Examples 6 and 7 (Figure 9), respectively.

Figure 6 is a schematic perspective illustration of an ink jet drawing system adopted in the process of the invention.

### DESCRIPTION OF THE PREFERRED EMBODIMENTS

In the process of the present invention for producing an organic luminescence device of the type comprising: a pair of electrodes, and a layer of organic material disposed between the electrodes so as to cause luminescence in response to a voltage applied between the electrodes; a wet-patterning step using an ink of the organic material within a hydrophobic organic solvent having a dissolving power of at most 5 wt. % of water at room temperature is adopted for producing the organic material layer.

In the process of the present invention, the (low-molecular weight) organic material may be dissolved within a hydrophobic organic solvent. The wet-patterning step may be effected as an offset printing step wherein an organic material placed on an intaglio plate is once transferred onto a blanket and then to a substrate of the organic luminescence device. Alternatively, the wet-patterning step may be effected as an ink jet printing step wherein minute liquid droplets containing an organic material are ejected onto and fixed in pattern on a substrate of the organic luminescence device. By the wet-patterning step, it is possible to form a luminescence layer for emitting colors of luminescences corresponding to red, green and blue pixels. According to the process of the present invention, it is possible to form a full-color display panel comprising high-performance organic luminescence devices arranged in a form of so-called simple matrix-type, active matrix-type, etc.

Hereinbelow, the present invention will be described more specifically with reference to drawings.

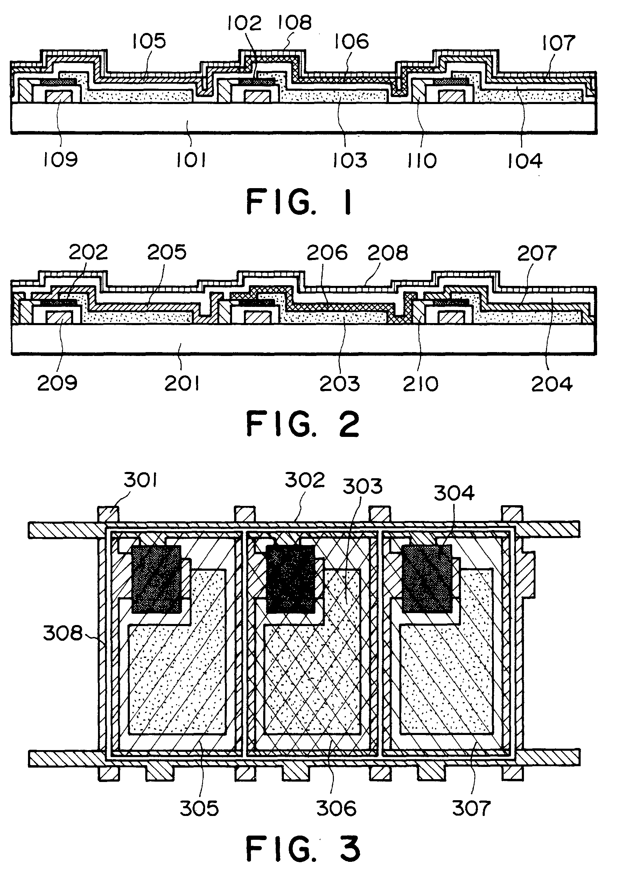

For example, an active matrix-type organic EL full-color display panel as illustrated in Figure 3 may have a structure including signal lines 301, gate lines 302, pixel electrodes 303 and thin-film transistors 304 formed on a substrate, which are further coated with organic luminescence layers 305, 306 and 307 of red, green and blue, respectively, disposed in alignment with the respective members 301 - 304. The signal lines 301, the gate lines 302 and the pixel electrodes 303 are connected to the sources, gates and drains, respectively, of the thin film transistors 304. The organic luminescence layers 305, 306 and 307 have been formed by subjecting solutions of respective luminescent low-molecular weight (or monomeric) organic materials (organic EL materials) in a hydrophobic organic solvent to wet-patterning, i.e., application in a pattern or printing.

The organic EL material may preferably have a molecular weight of at most 5000 in order to increase the impurity thereof to exhibit stable performances. The organic EL material may comprise at least one species of material selected from luminescent materials, hole-injecting materials, electron-injecting materials, hole-transporting materials and electron-transporting materials. The organic material may comprise a hole-transporting material or an electron-transporting material doped with a luminescent material, or an electron-injecting material or an electron-transporting material doped with a luminescent material, so as to increase the latitude or range of the respective colors. Further, it is also possible to dispose a plurality of organic material layers between a pair of electrodes to form a luminescence device.

In order to provide an organic luminescence layer exhibiting good luminescence efficiency, the organic luminescence layer may comprise an organic material in an amorphous state. For this purpose, it is preferred to adopt a material having a difference of at least 50 °C between its melting point (Tmp) and glass transition point (Tg).

The organic luminescent materials of respective colors may be selected from triacrylamine derivatives, stilbene derivatives, polyarylenes, aromatic condensated polycyclic compounds, aromatic heterocyclic compounds, aromatic condensed heterocyclic compounds, metal complex compounds, and homo-oligomers or composite oligomers of these. These are however not exhaustive.

Hole-injecting and hole-transporting materials may include: soluble phthalocyanine compounds, triarylamine compounds, electroconductive polymers, perylene compounds, and Eu complexes. These are however not exhaustive.

Electron-injecting and electron-transporting materials may include: Alq3 that is an aluminum complex formed by coordination of three molecules of hydroxyquinoline onto an aluminum atom, azomethine zinc complexes, and distyrylbiphenyl derivatives. These are however not exhaustive.

In order to form an organic luminescence layer through a wet-patterning step according to the present invention, such an organic EL material may be diluted or dissolved in a hydrophobic organic solvent having a dissolving power of at most 5 wt. % of water, i.e., a solvent in which water cannot be dissolved in a proportion in excess of 5 wt. %, at room temperature. Examples of such a hydrophobic organic solvent may include: chloroform, toluene, carbon tetrachloride, dichloroethane, tetrachloroethane, xylene, cymene, cyclohexanone, octylbenzene, dodecylbenzene, decalin, quinoline, chlorobenzene, dichlorobenzene, trichlorobenzene, thymol, nitrobenzaldehyde, nitrobenzene, carbon disulfide, 2-heptanone, benzene, terpineol, butyl carbitol acetate, and cellosolves. These solvents may be used singly or in mixture of two or more species. It is sometimes preferred to use a solvent mixture in order to provide an appropriate degree of drying characteristic of the resultant ink of organic material suitable for the wet patterning. The above-mentioned solvents are not exhaustive. It is possible to use a minor amount of hydropholic solvent in mixture with the hydrophobic organic solvent. In this case, however, the dissolving power for water of the resultant mixture solvent should be suppressed to at most 5 wt. %.

It is possible to form the organic luminescence layer, the electron-injecting and -transporting layer(s) and the hole-injecting and -transporting layer(s), by dispersing the respective functional materials in an appropriate binder resin.

The organic (luminescence) layer may be a layer having two or more of such functions in combination. It is further possible to dispose an additional layer having a function of, e.g., hole-transportation, in addition to the organic luminescence layer. Such an additional layer may also be formed through a wet-patterning step to form an organic luminescence layer in a laminate structure so as to improve the luminescence efficiency or/and simplify the production process.

The organic luminescence layer may be formed in a thickness in the range of 0.005 - 0.3 µm, preferably 0.05 - 0.15 µm. The thickness range may be adopted in each organic layer when a laminate luminescence layer structure including a plurality of such organic layers is adopted.

The wet-patterning step adopted in the process of the present invention may for example be effected as an offset printing step which allows a high-accuracy and high-definition printing in an inexpensive and stable manner, or an ink jet printing step suitable for patterning of a low-viscosity ink. The wet-patterning step is not however necessarily restricted to these printing steps.

The offset printing step may basically be realized by using a sheet-feeding type offset machine suitable for proofing, but it is preferred to remodel such a machine so as to provide a better positional accuracy and allow accurate setting of printing conditions than in ordinary waterless offset machine or intaglio printing machine for printing on papers.

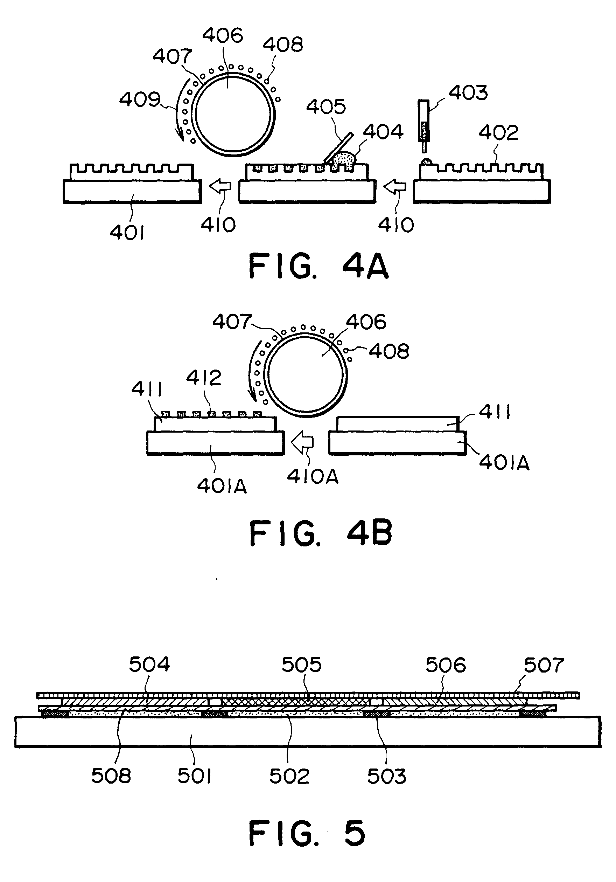

A manner of formation of an organic luminescence layer by using an offset printing machine is described with reference to Figures 4A and 4B, which are schematic sectional views for illustrating an offset printing system. Referring to these figures, the offset printing system includes a printing stage 401, an intaglio plate 402 set on the stage, an ink ejector 403 for ejecting an ink (a solution of organic EL material), an ink pool 404, a doctor blade 405, a blanket cylinder 406 on which a blanket 407 of silicone is disposed to carry a received ink 408. An arrow 409 represents a direction of rotation of the blanket cylinder 406, arrows 410 represent a direction of movement of the printing stage 402. Referring further to Figure 4B, the system further includes a printing stage 401A moving in the direction of an arrow 410A and carrying a substrate to be printed 411 for receiving an ink pattern 412 transferred from the blanket cylinder.

More specifically, as shown in Figure 4A, an ink formed by dissolving an organic EL material within a hydrophobic organic solvent is allowed to drip onto the intaglio plate 402 from the ink ejector 403. Then, the ink is scraped by the doctor blade 405 to fill the concavities of the intaglio plate 402. The blanket 407 wound about the blanket cylinder 406 is caused to contact the intaglio plate 402 at a prescribed pressure to receive the ink filling the plate 402 onto its surface. Then, the blanket 407 carrying the received ink 408 is caused to contact a substrate (substrate-to-be-printed) 411 of an organic EL display panel to be produced at a prescribed pressure to transfer an ink pattern from the blanket 407 onto the surface of the substrate 111.

The ink used in the offset printing step may preferably have a viscosity of at most 5000 cp. While an optimum ink viscosity can vary depending on the thickness and pattern of printed ink, and further on the surface properties of the blanket and the intaglio plate, a higher viscosity is liable to cause poor filling of the intaglio plate and leave entrapped bubbles. Particularly in the case of forming a thin ink pattern (in a wet state), a further lower viscosity of at most 100 cp is preferred.

The ink transfer performance in the offset printing process is determined based on a balance among surface energies of the intaglio plate, the blanket and the substrate-to-be-printed, and it is preferred that they have surface energies increasing in this order. It is sometimes effective to activate the substrate surface by irradiation with ultraviolet rays or plasma for generating ozone to treat the substrate surface. It is also preferred for the ink to exhibit a capability of wetting such a substrate surface, i.e., a surface energy of 20 - 60 dyne/cm, preferably 28 - 50 dyne/cm.

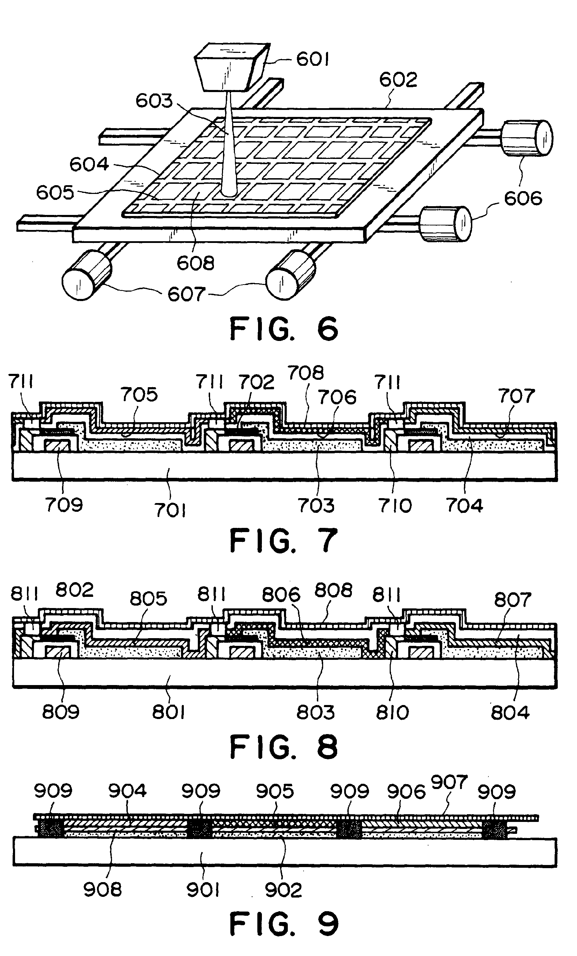

Next, a manner of formation of an organic luminescence layer by using an ink jet printing machine will now be described with reference to Figure 6, which is a schematic perspective illustration of an ink jet printing system. Referring to Figure 6, the system includes an ink jet head 601 for ejecting an ink (a solution of organic EL material) onto a substrate (of, e.g., glass) of an organic EL display panel to be produced supported on an XY-stage 602 which is moved in X and Y directions by means of an X-axis moving mechanism 606 and a Y-axis moving mechanism 607.

The ink jet printing system illustrated in Figure 6 has been organized based on a concept adopted in a stepper as a semiconductor device production apparatus. In this system, the substrate 604 can be accurately moved by the X-axis drive mechanism 66 and the Y-axis drive mechanism 607, whereby the ink 603 containing the monomeric organic EL material can be ejected onto an exact position as desired on the substrate 604. The ink jet head 601 may be either of a so-called bubble jet type according to an ejection scheme using a thermal energy or of a piezo jet type using a piezoelectric device for ink ejection. The ink used for the ink jet printing may preferably have a viscosity of at most 100 cp so as to stably effect the ejection and fixation of the ink. While the optimum ink viscosity range can vary depending on the ink ejection scheme, it is generally difficult to eject a high-viscosity ink by an ink jet printing scheme using a relatively small ejection energy. Particularly, in the case of forming a thin ink pattern (in a wet state), a further lower viscosity of at most 20 cp is preferred. Further, in order to form pixels 608 as printed portions separated from each other with non-pixel portions 605 as non-printed portions by utilizing a difference in surface energy of these portions on a substrate, it is sometimes effective to provide an increased surface energy difference between these portions. The ink may preferably exhibit a surface energy of 20 - 60 dyne/cm, more preferably 28 - 50 dyne/cm, at the printed parts.

In order to obtain a high-definition and high-accuracy pixel arrangement, it is preferred to form a partitioning wall at the non-pixel positions 605 for separating the pixels of red, green and blue by offset printing or photolithography in advance of the ink jet printing step. The partitioning wall 605 may preferably be formed from an ink comprising a resin which can be thermally cured or photocured into a state that is resistant to the organic EL material and the hydrophobic organic solvent mixed therewith. Examples of the resin may include: epoxy resin and acrylic resin: The partitioning wall may be formed in any colors, but a black-colored resin may be preferred so as to exhibit a black matrix effect or a supplementary black matrix effect for providing a display picture of a clear or neat appearance.

Hereinbelow, the present invention will be described more specifically based on Examples, but it should be understood that the present invention is not restricted to these Examples.

### (Example 1)

An active matrix-type organic EL full-color display panel having a planar structure and a sectional structure as illustrated in Figures 3 and 1, respectively, was prepared in the following manner.

As shown in Figure 1, signal lines 109, gate lines 110 and thin-film transistors 102 were first formed on a glass substrate 101, and then an ITO film was formed thereon and patterned to provide transparent pixel electrodes 103. The sources, gates and drains of the thin-film transistors 102 were connected to the signal lines 109, the gate lines 110 and the pixel electrodes 103, respectively. Thus, a treated substrate was provided.

Then, triphenylamine hexamer (abbreviated hereinafter as "TPA-6", having a molecular weight (M.W.) = 1461, Tmp = 277 °C, Tg = 156 °C) as a hole-injecting material was dissolved in toluene to form a 0.5 wt. % solution (a hole injection layer-forming ink), which was then applied by spin coating onto the above-treated substrate, followed by drying under heating at 80 °C for 10 min. to form a 0.05 µm-thick hole injection layer 104.

Separately, each of a blue luminescent material (9,9-dioctylfluorene pentamer ("DOFL-5"), M.W. = 1945, Tmp = 210 °C, Tg = 123 °C), a green luminescent material (DOFL-5 doped with 1.0 wt. % of coumarin) and a red luminescent material (DOFL-5 doped with 1.0 wt. % of 4-(dicyanomethylene)-2-methyl-6-(4-dimethylaminostyryl)-4-H-pyran ("DCM")), was separately dissolved in toluene at a concentration of 1 wt. % and then diluted with an equal amount of terpineol, to form 0.5 wt. % solutions of the blue, green and red luminescent materials, respectively, which are hereinafter called blue, green and red luminescence layer-forming inks.

Then, by using an offset printing apparatus as illustrated in Figures 4A and 4B, the above prepared blue, green and red luminescence layer-forming inks were separately and successively applied in respective patterns on the hole injection layer 104 prepared on the substrate, with intermediate drying at 80 °C for 10 min. between successive printing steps for the respective inks.

In each ink application, the ink was placed and filled into an intaglio plate 402 having a depth of 15 µm by a doctor blade 405, and a silicone rubber blanket 407 was pressed onto the plate 402 moved at a speed of 20 mm/sec at a pressure giving a blanket pressing depth of 50 µm to receive an ink pattern 408. Thereafter, the ink pattern 408 was transferred as an ink pattern 412 on a substrate 411 held on a stage-401A at similar printing speed and pressure. As a result, red, green and blue luminescence layers 105, 106 and 107 each in a thickness of 0.05 µm were formed on the hole injection layer 104 as shown in Figure 1.

Then, a 0.1 to 0.2 µm-thick MgAg electrode (Mg/Ag = 10/1 by weight) 108 was formed by vacuum deposition at a vacuum of 10⁻⁵ to 10⁻⁶ torr and a thickness increasing rate of 10 Å/sec. on the luminescence layers 105, 106 and 107 to provide a reflection type active full-color organic EL display panel of 40 mm x 40 mm in planar size including pixels each of 0.4 mm x 0.4 mm. As a result of drive at a constant voltage of 6 volts and 1/80 duty, the organic EL display panel exhibited stable luminescence over a long period.

### (Example 2)

An active matrix-type organic EL full-color display panel having a planar structure also as illustrated in Figure 3 and having a sectional structure as shown in Figure 2 was prepared in the following manner.

As shown in Figure 2, on a glass substrate 201, signal lines 209, gate lines 210 and thin-film transistors 202 were formed, and then AlLi alloy (Li = 1 wt. %) reflection pixel electrodes 203 were formed by vacuum deposition through a mask at a vacuum of 10⁻⁵ to 10⁻⁶ torr and a deposition rate of 10 Å/sec. so as to provide similar connections between the transistors and the electrodes as in Example 1.

Then, the same blue, green and red luminescence layer-forming inks as prepared in Example 1 each having a luminescent material content of 0.5 wt. % in a toluene/terpineol mixture solvent were successively applied in pattern by using an offset printing machine as illustrated in Figures 4A and 4B to form luminescence layers 205, 206 and 207 each in a thickness of 0.05 µm.

Then, a 0.5 wt. % solution in toluene of TPA-6 as a hole-injection material prepared in the same manner as in Example 1 was applied as a coating by extrusion onto the luminescence layers 205, 206 and 207, followed drying under heating to provide a 0.05 µm-thick hole injection layer 204.

Finally, an ITO transparent electrode 208 was formed by DC sputtering to provide a reflection-type active full-color organic EL display panel. As a result of a constant voltage drive, the organic EL display panel exhibited stable luminescence over a long period.

### (Example 3)

An active matrix-type organic EL full-color display panel having a planar structure and a sectional structure as illustrated in Figures 3 and 8, respectively, was'prepared in the following manner.

First, as shown in Figure 8, signal lines 809, gate lines 810 and thin-film transistors 802 were formed on a glass substrate 801, and then ITO transparent pixel electrodes 803 were formed thereon.

Then, a partitioning wall was formed in a pattern (605 in Figure 6) by offset printing using a system as illustrated in Figures 4A and 4B and a high-viscosity (4000 cps) thermosetting acrylic resin ink ("OPTOMER-SS", available from JSR K.K.), followed by heating at 60 °C for 30 min., to form a 0.1 µm-high partitioning wall 811.

A hole injection layer ink comprising 0.5 wt. % solution of TPA-6 in toluene was prepared in the same manner as in Example 1.

A blue luminescence layer-forming ink was prepared as a 0.5 wt. % solution in toluene of tetraphenylbutadiene ("TPB", M.W. = 516, Tmp = 175.6 °C, Tg = 63 °C). A green luminescence layer-forming ink was prepared as a 0.5 wt. % solution in toluene of DPVBii (M.W. = 952, Tmp = 352.8 °C, Tg = 168.8 °C) doped with 5 mol. % of Lumogen Red represented by structural formulae shown below. A red luminescence layer-forming ink was prepared as a 0.5 wt. % solution in toluene of Alq₃ (M.W. = 459.44, Tmp ≧ 300 °C) doped with quinacridone derivative ("QD").

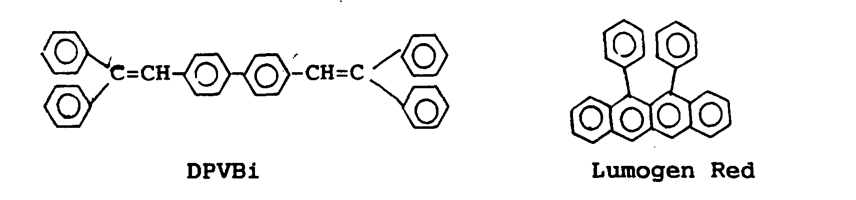

By using the above-prepared inks and an ink jet printing system as illustrated in Figure 6 (one made by Canon K.K. including Canon's BJ printer heads) the hole injection layer-forming ink was first ejected to all the pixels 608 defined by the partitioning wall and dried to form a 0.03 µm-thick layer, and then the blue, green and red luminescence layer-forming inks were successively ejected to the associated color pixels 608 and dried, to form blue, green and red luminescence layers 805, 806 and 807 each in a two-layer laminated structure having a total thickness of 0.05 µm, at the respective color pixels.

Then, all the pixels 608 and the partitioning wall 811 were coated with a 0.5 wt. % solution in toluene of Alq3 as an electron-injection and - transporting material by extrusion, followed by heating, to form a 0.05 µm-thick electron-injecting and -transporting layer 804.

Then, a 0.1 to 0.2 µm-thick MgAg reflection electrode 88 was formed by vacuum deposition on the electron-injecting and -transporting layer 804 to provide a reflection-type active full-color organic EL display panel. As a result of a constant voltage drive, the organic EL display panel exhibited stable luminescence over a long period.

### (Example 4)

An active matrix-type organic EL full-color display panel having a planar structure and a sectional structure as illustrated in Figures 3 and 7, respectively, was prepared in the following manner.

First, as shown in Figure 7, signal lines 709, gate lines 710 and thin-film transistors 702 were formed on a glass substrate 701, and then AlLi reflection pixel electrodes 703 were formed thereon. Thereafter, a 0.1 µm-high partitioning wall 711 was formed by offset printing similarly as in Example 3.

Over the substrate treated above, an electron-injecting and -transporting layer-forming ink of 0.5 wt. % solution of Alq3 in toluene was applied by extrusion, followed by sufficient levelling to fill the cells (pixels) defined by the partitioning wall 711, followed by heating for evaporation of the solvent, to form a 0.05 µm-thick electron-injecting and -transporting layer 704 at each pixel.

Then, by using the ink jet printing system illustrated in Figure 6 and used in Example 3, the blue, green an red luminescence layer-forming inks were first ejected onto the associated color pixels, and then the hole injection layer-forming ink was ejected to all the pixels in similar manners as in Example 3 but in a reverse order of ejection to form a blue, green and red luminescence layers each in a two-layer laminated structure having a total thickness of 0.05 µm at the respective color pixels.

Then, an ITO transparent electrode 708 was formed over the pixels by DC sputtering to provide a reflection-type active full-color organic EL display panel. As a result of a constant voltage drive, the organic EL display panel exhibited stable luminescence over a long period.

### (Example 5)

A passive matrix-type organic EL full-color display panel having a sectional structure as illustrated in Figure 5 was prepared in the following manner.

As shown in Figure 5, on a glass substrate 501, a plurality of transparent stripe electrodes 502 of TIO were formed and black stripes 503 were formed of UV-curable acrylic resin with carbon black dispersed therein ("OPTOMER CR" available from JSR K.K.) at spacings between the electrodes 502.

Then, a hole injection layer-forming ink of 0.5 wt. % solution of TPA-6 in toluene similar to the one used in Example 1 was applied by spin coating over the ITO electrodes 502, followed by heating for drying, to form a 0.05 µm-thick hole injection layer 508.

Then, the blue, green and red luminescence layer-forming inks prepared in Example 1 were printed on a square dot pattern similarly as in Example 1 according to an offset printing system as illustrated in Figures 4A and 4B to form blue, green and red luminescence layers 504, 505 and 506 each in a thickness of 0.05 µm.

Then, over the luminescence layers 504, 505 and 506, a 0.1 to 0.2 µm-thick MgAg reflection electrode 507 was formed by vacuum deposition through a mask in a pattern of stripes extending perpendicular to the stripe ITO electrodes 502, to provide a passive full-color organic EL display panel. As a result of a constant voltage drive, the organic EL display panel exhibited stable luminescence over a long period.

### (Example 6)

A passive matrix-type organic EL full-color display panel having a sectional structure as shown in Figure 9 was prepared in the following manner.

As shown in Figure 9, on a glass substrate 901, a plurality of transparent stripe electrodes 902 of ITO were formed.

Then, a black-colored high-viscosity (4000 cps) ink ("OPTOMER CR (BLACK)", made by JSR K.K.) was printed by an offset printing system as illustrated in Figures 4A and 4B, followed by heating at 60 °C for 30 min. to form a 0.1 µm-high partitioning wall 909 defining square cells (pixels) and also functioning as black stripes.

Then, a hole injection layer-forming ink of 0.5 wt. % solution in toluene of TPA-6 as a hole-injecting and -transporting material was applied by extrusion over the partitioning wall 909 and the ITO electrodes 902, and after sufficient levelling to fill the cells defined by the partitioning wall 909, were heated for evaporation of the solvent to form a 0.05 pm-thick hole injection layer 908 at each cell.

Then, the blue, green and red luminescence layer-forming inks of Example 1 were ejected to associated color pixels in a similar manner as in Example 3 by using an ink jet printing system as illustrated in Figure 6, to form blue, green and red luminescence layers 904, 905 and 906 each in a thickness of 0.05 µm.

Then, over the luminescence layers 904, 905 and 906, a 0.1 to 0.2 µm-thick MgAg reflection electrode 907 was formed by vacuum deposition through a mask in a pattern of stripes extending perpendicular to the stripe ITO electrodes 902, to provide a passive full-color organic EL display panel. As a result of a constant voltage drive, the organic EL display panel exhibited stable luminescence over a long period.

### (Example 7)

Another passive matrix-type organic EL full-color display panel also having a sectional structure as shown in Figure 9 was prepared in the following manner.

As shown in Figure 9, on a glass substrate 901, a plurality of transparent stripe electrodes 902 of ITO were formed.

Then, a 0.1 µm-high partitioning wall 909 defining square cells (pixels) and also functioning as black stripes was formed similarly as in Example 6.

Then, a hole injection layer-forming ink of 0.5 wt. % solution in toluene of TPA-6 as a hole-injecting and -transporting material was applied by extrusion over the partitioning wall 909 and the ITO electrodes 902, and after sufficient levelling to fill the cells defined by the partitioning wall 909, were heated for evaporation of the solvent to form a 0.05 µm-thick hole injection layer 908 at each cell.

Then, the blue, green and red luminescence layer-forming inks of Example 3 were ejected to associated color pixels in a similar manner as in Example 3 by using an ink jet printing system as illustrated in Figure 6, to form blue, green and red luminescence layers 904, 905 and 906 each in a thickness of 0.05 µm.

Then, over the luminescence layers 904, 905 and 906, a 0.1 to 0.2 µm-thick MgAg reflection electrode 907 was formed by vacuum deposition through a mask in a pattern of stripes extending perpendicular to the stripe ITO electrodes 902, to provide a passive full-color organic EL display panel. As a result of a constant voltage drive, the organic EL display panel exhibited stable luminescence over a long period.

### (Comparative Example 1)

An active matrix-type organic EL full-color display device having a planar structure and a sectional structure as illustrated in Figures 3 and 1, respectively, was prepared in a generally similar manner as in Example 1.

In this example however, each of the hole injection layer-forming ink and the blue, green and red luminescence layer-forming inks, was prepared by first dissolving a relevant functional organic material in toluene to form a 1.0 wt. % solution and then diluting the 1.0 wt. % solution with an equal amount of isopropyl alcohol to form a 0.5 wt. % solution.

As a result of a constant voltage drive, the organic EL display device substantially failed in luminescence.

### (Comparative Example 2)

An active matrix-type organic EL full-color display device having a planar structure and a sectional structure as illustrated in Figures 3 and 1, respectively, was prepared similar manner as in Comparative Example 1.

In this example however, each of the hole injection layer-forming ink and the blue, green and red luminescence layer-forming inks, was prepared by first dissolving a relevant functional organic material in toluene to form a 0.75 wt. % solution and then diluting the 1.0 wt. % solution with a half amount of isopropyl alcohol to form a 0.5 wt. % solution.

As a result of a constant voltage drive, the organic EL display device exhibited a lower initial luminance of about 1/2 and a faster luminance deterioration as represented by a half-attenuation period of 1/10, respectively compared with Example 1.

An organic luminescence device is formed from a pair of electrodes, and a layer of organic material disposed between the electrodes so as to cause luminescence in response to a voltage applied between the electrodes. The type of organic luminescence-device may be provided with improved luminescence performance if it is produced through a process including a wet-patterning step using an ink of the organic material within a hydrophobic organic solvent having a dissolving power of at most 5 wt. % of water at room temperature for producing the organic material layer.

## Claims

1. A process for producing an organic luminescence device of the type comprising: a pair of electrodes, and a layer of organic material disposed between the electrodes so as to cause luminescence in response to a voltage applied between the electrodes; wherein
said process comprises a wet-patterning step using an ink of the organic material within a hydrophobic organic solvent having a dissolving power of at most 5 wt. % of water at room temperature for producing the organic material layer.

2. A process according to Claim 1, wherein said wet-patterning step comprises an Offset printing step wherein the ink of the organic material placed on an intglio plate is transferred onto a blanket and then to a substrate of the organic luminescence device.

3. A process according to Claim 1, wherein said wet-patterning step comprises an ink jet printing step wherein minute droplets of the ink of the organic material are ejected onto and fixed in pattern on a substrate of the organic luminescence device.

4. A process according to Claim 1, wherein a luminescence layer for emitting colors of luminescences corresponding to red, green and blue pixels is formed by the wet-patterning step.

5. A process according to Claim 1, further including a step of forming a partitioning wall for separating the red, green and blue pixels from each other.

6. A process according to Claim 1, wherein the organic material has a molecular weight of at most 5000.

7. A process according to Claim 1, wherein the organic material layer comprises the organic material in an amorphous state.

8. A process according to Claim 1, wherein the organic material has a difference of at least 50 °C between its melting point and glass transition point.

9. A process according to Claim 1, wherein the organic material is a material functioning as at least one species selected from the group consisting of luminescent materials, hole-injecting materials, electron-injecting materials, hole-transporting material, and electron transporting materials.

10. A process according to Claim 1, wherein the organic material comprises a hole-injecting material or a hole-transporting material doped with a luminescent material.

11. A process according to Claim 1, wherein the organic material comprises an electron-injecting material or an electron-transporting material doped with a luminescent material.

12. A process according to Claim 1, wherein the organic material comprises a material capable of transmitting both holes and electrons doped with a luminescent material.

13. A process according to Claim 1, wherein a plurality of organic material layers are disposed between the pair of electrodes.

14. A process according to Claim 1, including a step of forming one of the electrodes on a substrate, a step of forming plural layers including the organic material layer on the electrode and a step of forming the other of the electrodes on the plural layers.

15. A process according to Claim 14, wherein said one and the other of the electrodes are respectively provided in a plurality so as to form a passive matrix electrode structure.

16. A process according to Claim 1, including a step of forming a plurality of thin-film transistors and a plurality of first electrodes connected to the transistors on a substrate, a step of forming plural layers including the organic material layer, and a step of forming a second electrode on the plural layers, so that each first electrode and the second electrode are disposed to form said pair of electrodes between which the organic material layer is disposed.

17. A process according to Claim 1, wherein the plurality of thin-film transistors, the plurality of first electrodes and the second electrode are arranged to form an active matrix electrode structure.

18. A process according to Claim 1, wherein the organic material layer is formed in a thickness of 0.005 - 0.3 µm.

19. A process according to Claim 1, wherein the hydrophobic organic solvent is selected from the group consisting of chloroform, toluene, carbon tetrachloride, dichloroethane, tetrachloroethane, xylene, cymene, cyclohexanone, octylbenzene, dodecylbenzene, decalin, quinoline, chlorobenzene, dichlorobenzene, trichlorobenzene, thymol, nitrobenzaldehyde, nitrobenzene, carbon disulfide, 2-heptanone, benzene, terpineol, butyl carbitol acetate, and cellosolves.

20. A process according to Claim 2, wherein the ink of the organic material has a viscosity of at most 5000 cp.

21. A process according to Claim 2, wherein the ink of the organic material has a surface energy of 20 - 60 dyne/cm.

22. A process according to Claim 3, wherein the ink of the organic material has a viscosity of at most 100 cp.

23. A process according to Claim 3, wherein the ink of the organic material has a surface energy of 20 - 60 dyne/cm.

24. An organic luminescence device prepared by a process according to any one of Claims 1 - 23.
